(19) Europäisches Patentamt
European Patent Office
Office européen des brevets

(11) **EP 4 645 314 A2**

(12) **EUROPEAN PATENT APPLICATION**

(43) Date of publication:
**05.11.2025 Bulletin 2025/45**

(21) Application number: **25170411.0**

(22) Date of filing: **14.04.2025**

(51) International Patent Classification (IPC):
**G11C 11/16** (2006.01)   **G11C 11/18** (2006.01)
**H03K 19/17796** (2020.01)   **H10N 52/80** (2023.01)

(52) Cooperative Patent Classification (CPC):
**G11C 11/1655; G11C 11/161; G11C 11/1659;
G11C 11/1673; G11C 11/1675; G11C 11/18;
H03K 19/17796; H10N 52/80**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **15.04.2024   US 202463634183 P
11.04.2025   US 202519176337**

(71) Applicant: Everspin Technologies, Inc.
Chandler, Arizona 85226 (US)

(72) Inventors:
• **MANCOFF, Frederick B.**
Chandler, AZ 85226 (US)
• **IKEGAWA, Sumio**
Chandler, AZ 85226 (US)
• **ALAM, Syed M.**
Chandler, AZ 85226 (US)
• **WILLIAMS, Jacob T.**
Chandler, AZ 85226 (US)

(74) Representative: **Eisenführ Speiser
Patentanwälte Rechtsanwälte PartGmbB
Johannes-Brahms-Platz 1
20355 Hamburg (DE)**

(54) **CONFIGURATION BIT WITH SPIN-ORBIT TORQUE**

(57)     A configuration bit includes a first set of magnetic tunnel junctions (MTJs) having a first polarity and a second set of MTJs having a second polarity opposite the first polarity. The configuration bit further includes a reading device electrically connected to the first set of MTJs and to the second set of MTJs, the reading device configured to read the first polarity of the first set of MTJs and the second polarity of the second set of the MTJs. Each MTJ in the first set of MTJs and each MTJ in the second set of MTJs is electrically connected to a spin orbit torque (SOT) channel layer configured to, when a current is applied to the SOT channel layer, control the polarities of the first set of MTJs and the second set of MTJs based on a direction of the current.

FIG. 1A

EP 4 645 314 A2

Description

## CROSS-REFERENCE TO RELATED APPLICATION

This application claims benefit to U.S. Provisional Patent Application No. 63/634,183, filed April 15, 2024, the entire contents of which are incorporated herein by reference.

## TECHNICAL FIELD

The disclosure herein relates generally to systems and methods for writing a memory device, and, more particularly, using spin orbit torque to write a memory device.

## INTRODUCTION

Each integrated circuit chip may include billions of devices thereon, including memory devices such as magnetoresistive tunnel junctions (MTJs). MTJs may be written (e.g., assigned a logical state) by changing the magnetic orientation of the magnetic free layer within an MTJ stack. MTJs may be written a number of ways, including through changing the orientation of the free layer by applying an electrical current in such a way that the orientation is changed by either spin transfer torque (STT) or spin orbit torque phenomena. Writing MTJs with STT, however, may damage an insulator layer (e.g., a tunnel barrier) within the MTJ. It is thus desirable to write MTJ devices without damaging the insulator layer therein.

## BRIEF DESCRIPTION OF DRAWINGS

In the course of the detailed description that follows, reference will be made to the appended drawings. The drawings show different aspects of the present disclosure and, where appropriate, reference numerals illustrating like structures, components, materials, and/or elements in different figures are labeled similarly. It is understood that various combinations of the structures, components, and/or elements, other than those specifically shown, are contemplated and are within the scope of the present disclosure.

Moreover, there are many embodiments of the present disclosure described and illustrated herein. The present disclosure is neither limited to any single aspect nor embodiment thereof, nor to any combinations and/or permutations of such aspects and/or embodiments. Moreover, each of the aspects of the present disclosure, and/or embodiments thereof, may be employed alone or in combination with one or more of the other aspects of the present disclosure and/or embodiments thereof. For the sake of brevity, certain permutations and combinations are not discussed and/or illustrated separately herein; however, all permutations and combinations are considered to fall within the scope of the present inventions.

FIG. 1A depicts a three-terminal memory cell of an exemplary magnetoresistive device.

FIGS. 1B and 1C depict a configuration bit with spin-transfer torque (STT).

FIGS. 2A and 2B depict an exemplary configuration bit with spin-orbit torque (SOT) during a write operation, according to one or more embodiments.

FIGS. 3A and 3B depict an exemplary configuration bit with SOT during a read operation, according to one or more embodiments.

FIGS. 4A and 4B depict an exemplary configuration bit with SOT during a write operation, according to one or more embodiments.

FIGS. 5A and 5B depict an exemplary configuration bit with SOT during a read operation, according to one or more embodiments.

FIGS. 6A and 6B depict an exemplary configuration bit with SOT during a write operation, according to one or more embodiments.

FIGS. 7A and 7B depict an exemplary configuration bit with SOT during a read operation, according to one or more embodiments.

FIGS. 8A and 8B depict an exemplary configuration bit with SOT during a write operation, according to one or more embodiments.

FIGS. 9A and 9B depict an exemplary configuration bit with SOT during a read operation, according to one or more embodiments.

FIGS. 10A, 10B, and 10C depict exemplary SOT channel regions, according to one or more embodiments.

Again, there are many embodiments described and illustrated herein. The present disclosure is neither limited to any single aspect nor embodiment thereof, nor to any combinations and/or permutations of such aspects and/or embodiments. Each of the aspects of the present disclosure, and/or embodiments thereof, may be employed alone or in combination with one or more of the other aspects of the present disclosure and/or embodiments thereof. For the sake of brevity, many of those combinations and permutations are not discussed separately herein.

## DETAILED DESCRIPTION

Detailed illustrative aspects are disclosed herein. However, specific structural and functional details disclosed herein are merely representative for purposes of describing example embodiments of the present disclosure. The present disclosure may be embodied in many alternate forms and should not be construed as limited to only the embodiments set forth herein. Further, the terminology used herein is for the purpose of describing particular embodiments only and is not intended to be limiting of exemplary embodiments described herein.

When the specification makes reference to "one embodiment" or to "an embodiment," it is intended to mean that a particular feature, structure, characteristic, or function described in connection with the embodiment being discussed is included in at least one contemplated embodiment of the present disclosure. Thus, the appearance of the phrases, "in one embodiment" or "in an embodiment," in different places in the specification does not constitute a plurality of references to a single embodiment of the present disclosure.

As used herein, the terms "comprises," "comprising," or any other variation thereof, are intended to cover a non-exclusive inclusion, such that a process, method, article, or apparatus that comprises a list of elements does not include only those elements, but may include other elements not expressly listed or inherent to such process, method, article, or apparatus. The term "exemplary" is used in the sense of "example," rather than "ideal."

As used herein, the singular forms "a," "an," and "the" are intended to include the plural forms as well, unless the context clearly indicates otherwise. It also should be noted that in some alternative implementations, the features and/or steps described may occur out of the order depicted in the figures or discussed herein. For example, two steps or figures shown in succession may instead be executed substantially concurrently or may sometimes be executed in the reverse order, depending upon the functionality/acts involved. In some aspects, one or more described features or steps may be omitted altogether, or may be performed with an intermediate step therebetween, without departing from the scope of the embodiments described herein, depending upon the functionality/acts involved.

Further, the terms "first," "second," and the like, herein do not denote any order, quantity, or importance, but rather are used to distinguish one element from another. Similarly, terms of relative orientation, such as "top," "bottom," etc. are used with reference to the orientation of the structure illustrated in the figures being described. It should also be noted that all numeric values disclosed herein may have a variation of $\pm 10\%$ (unless a different variation is specified) from the disclosed numeric value. Further, all relative terms such as "about," "substantially," "approximately," etc. are used to indicate a possible variation of $\pm 10\%$ (unless noted otherwise or another variation is specified).

In the interest of conciseness, conventional techniques, structures, and principles known by those skilled in the art may not be described herein, including, for example, standard magnetoresistive random access memory (MRAM) process techniques, generation of bias voltages, fundamental principles of magnetism, and basic operational principles of memory devices.

For the sake of brevity, conventional techniques related to accessing (e.g., reading or writing) memory, and other functional aspects of certain systems and subsystems (and the individual operating components thereof) may not be described in detail herein. Furthermore, the connecting lines shown in the various figures contained herein are intended to represent exemplary functional relationships and/or physical couplings between the various elements. It should be noted that many alternative or additional functional relationships or physical connections may be present in an embodiment of the subject matter.

The magnetic tunnel junction (MTJ) is a fundamental unit of a memory array and may include, among other things, two magnetic layers on opposite sides of an insulator. The two magnetic layers may include a fixed magnetic layer (also known as the reference layer) with a fixed magnetic moment and a free layer with a non-fixed (e.g., changeable) magnetic moment. By changing the direction of the magnetic moment of the free layer, the logical state of the MTJ may be changed (also known as "programming" or "writing" the MTJ). MTJs may be written by changing the orientation of the magnetic moment of the free layer using an electric current. In spin torque transfer (STT) devices, the electric current flows through the MTJ layers and changes the orientation of the free layer by transferring the angular momentum of the electrons in the current to the electrons in the free layer. However, the current flowing through the MTJ may damage the insulator layer therein, leading to failure.

For example, for a configuration bit, a type of memory bit used in digital circuits and programmable devices to control hardware settings and functionalities which may be set during programming or initialization (e.g., a distributed MRAM configuration bit, such as the ones illustrated in U.S. Patent Application Number 18/590,543, which is incorporated herein by reference in its entirety), that uses multiple MTJs switched by spin torque transfer, STT currents flow through the tunnel barriers of the MTJs, which may cause the tunnel barriers to break down due to the electrical bias. This breakdown can limit the cycling endurance of the configuration bits or the amount of write bias that is able to be applied. Further, because STT write currents pass through the tunnel barriers, the resistance area (RA) product and resistance of the MTJs may need to be designed so that the MTJs can support the STT current. This constraint limits the ability to adjust the MTJ resistance for optimized read performance, as discussed herein. Furthermore, multiple MTJs are used for one configuration bit read by a small latch circuit instead of a large sense amplifier, in order to be robust against MTJ shorts and resistance variations. However, since the number of MTJs that can be written by one write circuit with a supply voltage VDD is limited to approximately two to three (as a write voltage across an MTJ in STT is high at around 0.3 - 0.5 V), multiple write circuits per configuration bit are required. Yet furthermore, although multiple MTJs may be connected in series to write simultaneously in an STT configuration, such series-connection of MTJs may not be robust against MTJ open failures at reading.

The present disclosure solves the above problems by implementing spin orbit torque (SOT) devices in configuration bits. This way, the write current does not pass through the tunnel barriers, and thus will not break down the tunnel barriers. Also, because an SOT device is a 3-terminal device (e.g., please see U.S. Patent Number 11,127,896, which is incorporated herein by reference in its entirety), the tunnel barrier RA and resistance can be designed solely for optimized read performance since the write current does not pass through the tunnel barrier. Further, because the SOT channel resistance per MTJ can be low (e.g., approximately 500 $\Omega$) and the write voltage across the SOT channel per MTJ can be low (e.g., approximately 0.05 V), a large number of MTJs (e.g., up to approximately 20) can be written by one write circuit with VDD (e.g., approximately 1 V), leading to a simpler and smaller write circuit. Furthermore, because multiple SOT devices can be connected by a common SOT channel, it is easier to connect multiple MTJs in parallel for read without sacrificing write simplicity. At reading, parallel-connection of multiple MTJs is robust against MTJ open failure.

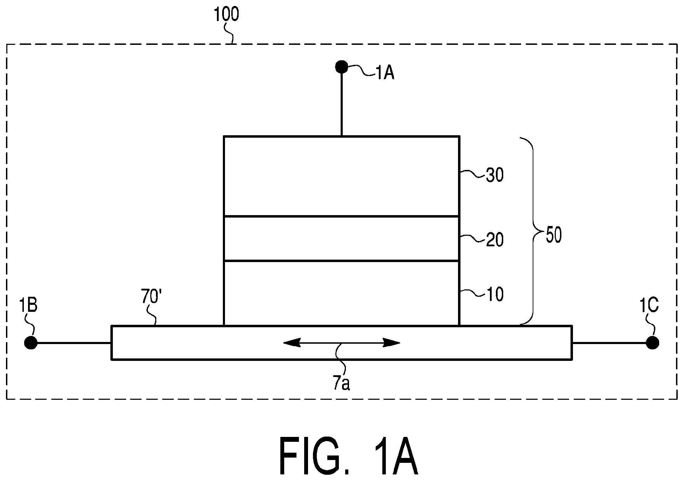

FIG. 1A illustrates a three-terminal memory cell of an exemplary magnetoresistive device, specifically an SOT-MRAM device. Memory cell 100 may include a magnetoresistive device, such as, e.g., MTJ 50 comprising an intermediate region 20 (e.g., tunnel barrier) positioned between a free region 10 and a fixed region 30. In some embodiments, the intermediate region 20 includes a dielectric material, such as, e.g., magnesium oxide (MgO). In other embodiments, the intermediate region 20 may include any suitable non-magnetic material. However, MTJ 50 may not be limited to the configuration/structure specifically discussed herein. In other words, MTJ 50 may have any now-known or future-developed configuration/structure of a magnetoresistive stack. U.S. Pat. Nos. 8,686,484; 8,747,680; 9,023,216; 9,136,464; and 9,419,208, and U.S. Patent Application Nos. 15/831,736 (filed December 5, 2017); 62/591,945 (filed November 29, 2017); 62/594,229 (filed December 4, 2017); 62/580,612 (filed November 2, 2017); 62/582,502 (filed November 7, 2017), 62/588,158 (filed November 17, 2017), and 62/653,796 (filed April 6, 2018) describe exemplary magnetoresistive stacks that may be used in the exemplary embodiments of the current disclosure. These U.S. patents and applications are incorporated by reference in their entireties herein.

It should be noted that, although exemplary embodiments in the disclosure are described and/or illustrated herein in the context of MTJ stacks/structures, embodiments may also be implemented in giant magnetoresistive (GMR) stacks/structures where a conductor (e.g., copper) is disposed between two ferromagnetic regions/layers/materials. Indeed, embodiments of the present disclosure may also be employed in connection with other types of magnetoresistive stacks (and/or structures), wherein such stacks include a fixed region, a free region, an intermediate region, etc. For the sake of brevity, the discussions and illustrations will not be repeated specifically in the context of GMR or other magnetoresistive stacks/structures -- but such discussions and illustrations are to be interpreted as being entirely applicable to GMR and other stacks/structures.

As shown in FIG. 1A, each memory cell 100 may include three terminals including terminal 1A, terminal 1B, and terminal 1C, all of which may permit electrical access to the MTJ 50 by allowing for electrical connectivity to circuitry and other elements of the SOT-MRAM device. The free region 10 of the MTJ 50 may be adjacent to or in electrical contact with an SOT write line 70' (or an SOT channel 70'), which may provide an SOT write current to switch the magnetic state of the free region 10. Each end of the SOT write line 70' may be connected, through an interconnect (e.g., electrode, via, etc.) for example, to a corresponding select device (e.g., access transistor), which may in turn be connected to a corresponding source line, to allow for the SOT write current to travel through the SOT write line 70' (e.g., to perform a write operation). For instance, one end of the SOT write line 70', e.g., terminal 1B, may be connected to a source line through a select device positioned therebetween, and the opposite end of the SOT write line 70', i.e., terminal 1C, may be connected to another source line through another select device positioned therebetween. Different voltages may be applied to these source lines to generate an SOT write current 7a through the SOT write line 70' in a desired direction (e.g., from terminal 1B to terminal 1C, or from terminal 1C to terminal 1B). As alluded to above, the direction of the SOT write current may determine the direction of the magnetic state of the free region 10.

Further, terminal 1A shown above the fixed region 30 of the MTJ 50 may be connected, through an interconnect (e.g., electrode, via, etc.) for example, to a bit line, which may provide a read current (i.e., sensing signal) through the MTJ 50 to read a magnetic state of the MTJ 50 (i.e., to perform a read operation). A suitable select device also may be provided between terminal 1A and the bit line. Forming each memory cell as a three-terminal device as depicted in FIG. 1A may lead to an increased memory cell area due to the terminal access electrodes or vias coupled thereto, and any other connected device(s). For example, such a three-terminal device may require at least three electrodes or vias coupled to the terminals 1A, 1B, 1C, to allow for electrical connectivity to circuitry and other elements of the SOT-MRAM device.

In some embodiments of the current disclosure, each horizontal array of memory cells in an SOT-MRAM device may be connected to a single, shared SOT write line. For example, in some embodiments, an SOT write line may extend adjacent to multiple, horizontally-spaced MTJ's in a horizontal array of memory cells, thereby forming a shared SOT write line. Particularly, the shared SOT write line that passes through the horizontal array may be adjacent to (e.g., in electrical contact with) the free regions of all the (or multiple) MTJ's 50 in the horizontal array. The formation of the shared SOT write line may result in an SOT-MRAM device having two terminals in each memory cell (e.g., one terminal connected to a bit line, the other terminal connected to a source line). The use of the shared SOT write line may thus lead to a reduced memory cell area, compared to that of the three-terminal memory cell discussed above with reference to FIG. 1A. For example, the exemplary memory devices of the current disclosure may require just two electrodes or vias per memory cell, compared to three electrodes or vias required by the memory cell depicted in FIG. 1A. Therefore, the contemplated embodiment may allow for an SOT-MRAM device with an increased density (i.e., more memory cells in a given area).

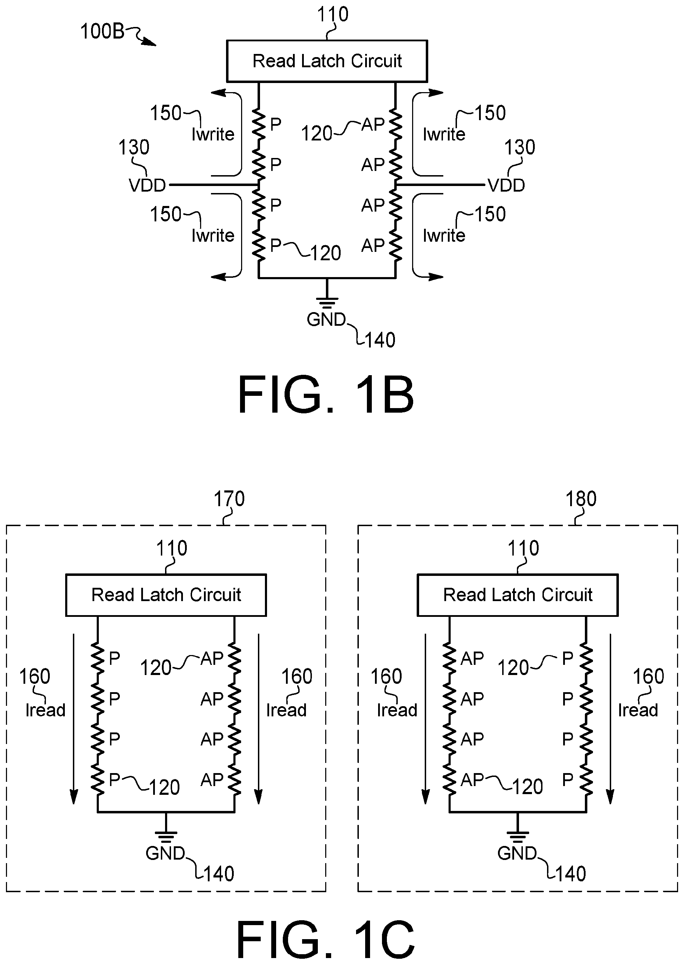

FIGS. 1B and 1C depict a configuration bit with spin-transfer torque (STT). FIG. 1B illustrates a write operation 100B for a configuration bit. The configuration bit on which write operation 100B is performed may include a read latch circuit 110, a plurality of MTJs 120, a VDD, a ground (GND) 140, and a write current 150. Each of the plurality of MTJs 120 may include a polarity (e.g., parallel (P) or anti-parallel (AP)) and may be electrically connected in series or in parallel to one another. The write current 150 may be provided from the VDD 130 through each of the plurality of MTJs 120 altering the polarity of each of the plurality of MTJs 120. As shown in FIG. 1B, each side or leg of the plurality of MTJs 120 may include MTJs 120 including the same polarity. For example, during a 0 state, the left-hand side MTJS 120 may all be parallel, while the right-hand side MTJs 120 may all be anti-parallel. During a 1 state, the left-hand side MTJs 120 may all be anti-parallel, while the right-hand side MTJs 120 may all be parallel.

FIG. 1C illustrates a read 0 operation 170 and a read 1 operation 180 after the write operation 100B of FIG. 1B. The read 0 operation 170 may include each of the plurality of MTJs 120 on the left-hand side being in the parallel state and the right-hand side being in the anti-parallel state. The read 1 operation 180 may include each of the plurality of MTJs 120 on the left-hand side being in the anti-parallel state and the right-hand side being in the parallel state. The read latch circuit 110 may provide a read current 160 through the left-hand side and the right-hand side and determine a difference in resistance between the two sides the plurality of MTJs 120 to determine the state of the configuration bit. As described above, the write operation 100B may provide a write current 150 through each of the plurality of MTJs 120, which may cause the tunnel barriers to break down over time due to the electrical bias. This break down may limit the cycling endurance of the configuration bits or may limit the magnitude of write bias that is able to be applied. By allowing the write current to pass through the tunnel barrier, the resistance area (RA) product and resistance of each MTJ may need to be designed so that the MTJs can support the STT current.

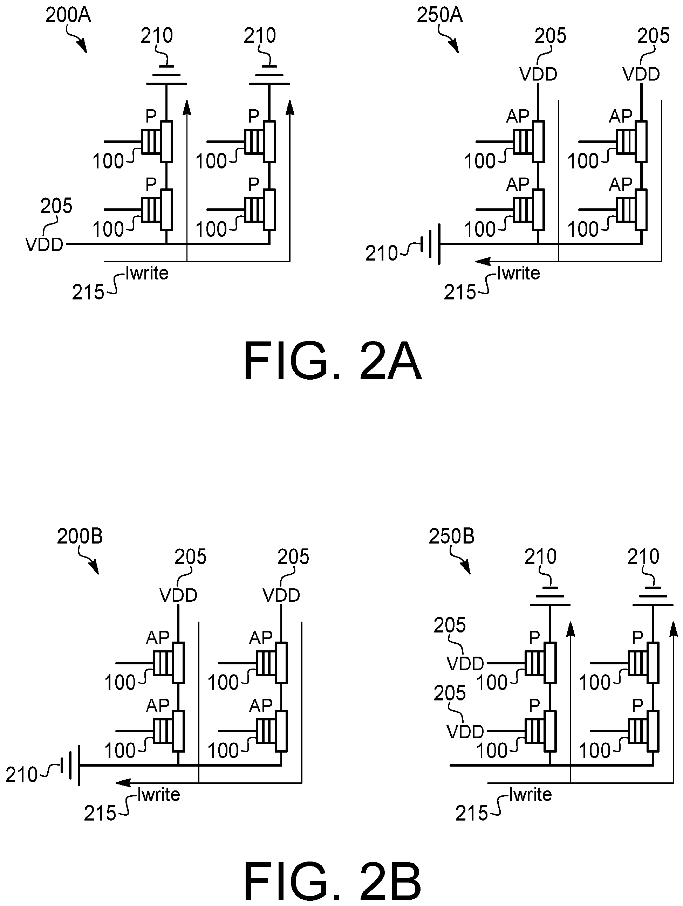

FIGS. 2A - 9B depict a plurality of SOT memory cells 100. Each SOT memory cell 100 depicted in FIGS.

2A - 9B may have an identical or substantially similar structure as those of the memory cell described in reference to FIG. 1A (with 3 or 2 terminals connected to each). For brevity, the SOT memory cell 100 will also be referred to herein as simply memory cell 100.

FIGS. 2A and 2B depict an exemplary configuration bit with spin-orbit torque (SOT) during a write operation, according to one or more embodiments. FIG. 2A illustrates a configuration bit with a first leg 200A (e.g., first set of memory cells 100 having a first polarity (e.g., parallel or "P")) and a second leg 250A (e.g., second set of memory cells 100 having a second polarity (e.g., antiparallel or "AP")) opposite the first polarity. Each leg has two sides, each side including one or more memory cells 100 connected in series. The logical state of the configuration bit may be based on the respective polarities of the plurality of memory cells 100 of the first leg 200A and the plurality of memory cells 100 of the second leg 250A. The logical state of the configuration bit may be, e.g., a logical 0 or 1 and may be written by applying an electrical current through a spin orbit torque (SOT) channel layer (e.g., SOT write line 70') electrically coupled to each MTJ (e.g., MTJ 50) in the first leg 200A and the second leg 250A in a first direction from a voltage source 205 (e.g., "VDD") to ground 210. As discussed above, SOT herein refers to changing the orientation or magnetic state of the free layer in an MTJ, leading to the generation of torque on the magnetic moments of the electrons in the free layer. Embodiments described herein may utilize what may be referred to as spin-orbit torque to switch or aid in switching the magnetic state of the free region in an MTJ or MTJ-like device, where such an MTJ device is often included in a memory cell in a magnetic memory. A charge current through a conductor (e.g., an SH material) referred to as an SOT channel, adjacent to (and/or in contact with) the free region results in a spin torque acting on the free region due to the injection of a spin current into the free region from the spin-dependent scattering of electrons or spin-orbit interaction in the conductor (e.g., an SH material). This may be referred to as a spin Hall effect. The spin current is injected into the free region in a direction perpendicular to the boundary (or interface) where the free region and the SH material meet, and orthogonal to the direction of the charge current flow. The spin torque applied to the free region by the spin current impacts the magnetic state of the free region in a manner similar to spin-polarized tunneling current that flows through the MTJ in traditional spin-torque or STT magnetic tunnel junctions. There is an additional mechanism which may give rise to spin-orbit torque. If a charge current flows parallel to an interface between the free region and the SH material, the flowing electrons become spin polarized at the interface due to spin-orbit coupling. The polarized electrons exert a torque on the magnetization of the free region. This may be referred as a Rashba-Edelstein effect or an inverse spin galvanic effect. As the function of STT magnetic tunnel junctions is well known in the art, it will not be further described here. In FIG. 2A, for example, the write current 215 may flow "up" in the first leg 200A containing the first set of memory cells 100, and the write current may flow "down" the second leg 250A containing the second set of memory cells 100, thereby writing the configuration bit to a first logical state. In FIG. 2B, which is the same as FIG. 2A except for the direction of the current, the current may flow "down" through the SOT write line 70' in the first leg 200B containing the first set of memory cells 100, and the current may flow "up" the second leg 250B containing the second set of memory cells 100, thereby writing the configuration bit to a second logical state opposite the first.

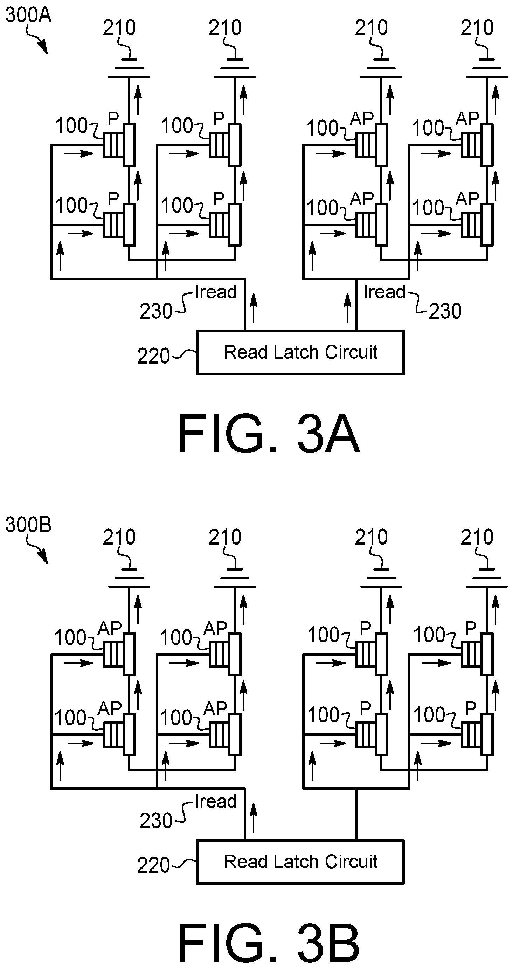

FIGS. 3A and 3B depict an exemplary configuration bit with SOT during a read operation, according to one or more embodiments. FIGS. 3A and 3B illustrate the read operation after the write operation according to FIGS. 2A and 2B, respectively. FIG. 3A illustrates the read operation 300A with a logical state 0 corresponding to the write operation with a logical state of 0 in FIG. 2A. Read operation 300A may include ground 210, a read latch circuit 220, and a read current 230. As discussed above with respect to FIG. 2A, the first leg (e.g., 200A) may include a plurality of memory cells 100 with a polarity of parallel and a second leg (e.g., 250A) may include a plurality of memory cells 100 with a polarity of anti-parallel. The read latch circuit 220 may be configured to provide the read current 230 through each of the plurality of memory cells 100 and their respective SOT write line 70' to ground 210. The read latch circuit 220 may determine a difference in resistance between the two legs (e.g., through determining the polarity of each memory cell 100 in the two legs) to determine the state of the configuration bit.

Similarly, FIG. 3B illustrates the read operation 300B with a logical state 1 corresponding to the write operation with a logical state of 1 in FIG. 2B. Read operation 300B may include ground 210, a read latch circuit 220, and a read current 230. As discussed above with respect to FIG. 2B, the first leg (e.g., 200B) may include a plurality of memory cells 100 with a polarity of anti-parallel and a second leg (e.g., 250B) may include a plurality of memory cells 100 with a polarity of parallel. The read latch circuit 220 may be configured to provide the read current 230 through each of the plurality of memory cells 100 and their respective SOT write line 70' to ground 210. The read latch circuit 220 may determine a difference in resistance between the two legs (e.g., through determining the polarity of each memory cell 100 in the two legs) to determine the state of the configuration bit. Using the memory cells 100 configured as described herein (e.g., using the SOT write line 70') may allow the tunnel barriers RA and resistance for each of the memory cells to be tuned as needed for a read operation without any effect on the write operation, since the write current does not pass through the tunnel barrier of each of the memory cells. The use of multiple memory cells for each leg may provide improved averaging of a read signal resulting in noise reduction. The use of multiple memory cells electrically connected in parallel for each leg may be effective against open failures during a read operation.

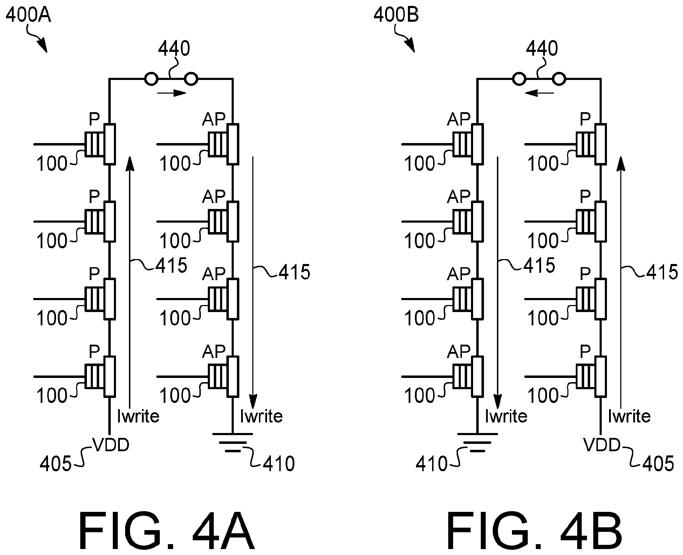

FIGS. 4A and 4B depict an exemplary configuration bit with SOT during a write operation, according to one or more embodiments. FIGS. 4A and 4B are substantially similar to FIGS. 2A and 2B, except that all of the memory cells are connected in electrical series through the SOT write line 70' for the write operations. FIG. 4A illustrates a write operation 400A (e.g., write 0) for a configuration bit with a plurality of memory cells 100. The write operation 400A may include a VDD 405, a plurality of memory cells 100, a ground 410, a write current 415, and a switch 440. Each of the plurality of memory cells 100 may be electrically connected in series with a first leg of memory cells 100 having a first polarity (e.g., parallel or "P") and a second leg of memory cells 100 having a second polarity (e.g., antiparallel or "AP") opposite the first polarity. The logical state of the configuration bit may be, e.g., a logical 0 or 1 and may be written by applying an electrical current through the SOT write line 70' electrically coupled to each MTJ (e.g., MTJ 50) as part of the memory cell 100 in a first direction from VDD 405 (e.g., voltage source) to ground 410. The write operation 400A may be configured to provide a single write current 415 that may flow through each of the memory cells 100 of the first leg, through the closed switch 440, and through each of the memory cells 100 of the second leg, thereby writing the configuration bit to a first logical state. Similarly, FIG. 4B illustrates the write operation 400B (e.g., write 1) for a configuration bit with a plurality of memory cells 100. The write current 415 may flow through each of the memory cells 100 of the second leg, through the closed switch 440, and through each of the memory cells 100 of the first leg, thereby writing the configuration bit to a second logical state. The write current 415 of FIG. 4B may flow in the opposite direction from the write current 415 of FIG. 4A. During both write operations of FIGS. 4A-4B, the switch 440 may be closed. An advantage of providing a single write current with all memory cells in electrical series may include a simpler write driver with less total current.

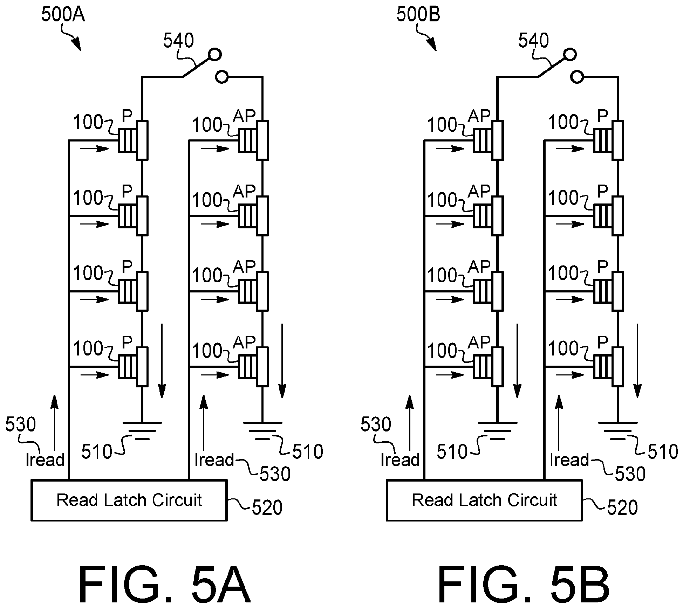

FIGS. 5A and 5B depict an exemplary configuration bit with SOT during a read operation, according to one or more embodiments. FIGS. 5A and 5B illustrate the read operation after the write operation according to FIGS. 4A and 4B, respectively. FIG. 5A illustrates the read operation 500A with a logical state 0 corresponding to the write operation with a logical state 0 in FIG. 4A. Read operation 500A may include ground 510, a read latch circuit 520, a read current 530, and a switch 540. As discussed above with respect to FIG. 4A, the first leg may include a plurality of memory cells 100 with a polarity of parallel and the second leg may include a plurality of memory cells 100 with a polarity of anti-parallel. The read latch circuit 520 may be configured to provide the read current 530 through each of the plurality of memory cells 100 connected in parallel in each of the first leg and the second leg, and through their respective SOT write line 70' to ground 510. The read latch circuit 520 may determine a difference in resistance between the two legs (e.g., through determining the polarity of each memory cell 100 in the two legs) to determine the state of the configuration bit. The switch 540 may be in the open configuration during a read operation to prevent current flowing between the first leg and the second leg.

Similarly, FIG. 5B illustrates the read operation 500B with a logical state 1 corresponding to the write operation with a logical state 1 in FIG. 4B. Read operation 500B may include ground 510, a read latch circuit 520, a read current 530, and a switch 540. As discussed above with respect to FIG. 4B, the first leg may include a plurality of memory cells 100 with a polarity of anti-parallel and a second leg may include a plurality of memory cells 100 with a polarity of parallel. The read latch circuit 520 may be configured to provide the read current 530 through each of the plurality of memory cells 100 connected in parallel in each of the first leg and the second leg, and through their respective SOT write line 70' to ground 510. The read latch circuit 520 may determine a difference in resistance between the two legs (e.g., through determining the polarity of each memory cell 100 in the two legs) to determine the state of the configuration bit. Simila to FIG. 5A, the switch 540 may be in the open configuration during a read operation to prevent current flowing between the first leg and the second leg. Using the memory cells 100 configured as described herein (e.g., using the SOT write line 70') may allow the tunnel barriers RA and resistance for each of the memory cells to be tuned as needed for a read operation without any effect on the write operation, since the write current does not pass through the tunnel barrier of each of the memory cells. The use of multiple memory cells for each leg may provide improved averaging of a read signal resulting in noise reduction. The use of multiple memory cells electrically connected in parallel for each leg may be effective against open failures during a read operation.

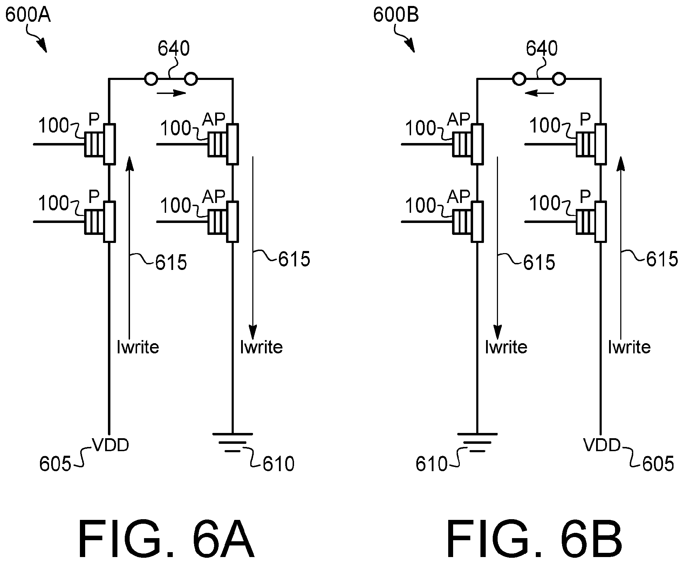

FIGS. 6A and 6B depict an exemplary configuration bit with SOT during a write operation, according to one or more embodiments. FIGS. 6A and 6B are substantially similar to FIGS. 4A and 4B, except the number of memory cells are reduced. FIG. 6A illustrates a write operation 600A (e.g., write 0) for a configuration bit with a plurality of memory cells 100. The write operation 600A may include a VDD 605, a plurality of memory cells 100, a ground 610, a write current 615, and a switch 640. Each of the plurality of memory cells 100 may be electrically connected in series with a first leg of memory cells 100 having a first polarity (e.g., parallel or "P") and a second leg of memory cells 100 having a second polarity (e.g., antiparallel or "AP") opposite the first polarity. The logical state of the configuration bit may be, e.g., a logical 0 or 1 and may be written by applying an electrical current through the SOT write line 70' electrically coupled to each MTJ (e.g., MTJ 50) as part of the memory cell 100 in a first direction from a VDD 605 (e.g., voltage source) to ground 610. The write operation 600A may be configured to provide a single write current 615 that may flow through each of the memory cells 100 of the first leg, through the closed switch 640, and through each of the memory cells 100 of the second leg, thereby writing the configuration bit to a first logical state. Similarly, FIG. 6B illustrates the write operation 600B (e.g., write 1) for a configuration bit with a plurality of memory cells 100. The write current 615 may flow through each of the memory cells 100 of the second leg, through the closed switch 640, and through each of the memory cells 100 of the first leg, thereby writing the configuration bit to a second logical state. The write current 615 of FIG. 6B may flow in the opposite direction from the write current 615 of FIG. 6A. During both write operations of FIGS. 6A-6B, the switch 640 may be closed. An advantage of providing a single write current with all memory cells in electrical series may include a simpler write driver with less total current.

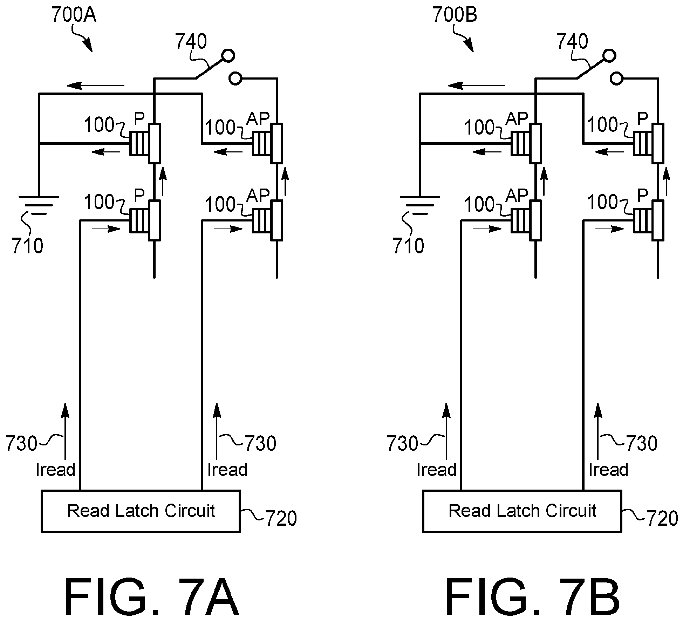

FIGS. 7A and 7B depict an exemplary configuration bit with SOT during a read operation, according to one or more embodiments. FIGS. 7A and 7B illustrate the read operation after the write operation according to FIGS. 6A and 6B, respectively. FIG. 7A illustrates the read operation 700A with a logical state 0 corresponding to the write operation with a logical state 0 in FIG. 6A. Read operation 700A may include ground 710, a read latch circuit 720, a read current 730, and a switch 740. As discussed above with respect to FIG. 6A, the first leg may include a plurality of memory cells 100 electrically connected in series with a polarity of parallel and a second leg may include a plurality of memory cells 100 electrically connected in series with a polarity of anti-parallel. The read latch circuit 720 may be configured to provide the read current 730 through each of the first leg and the second leg, each leg including a plurality of memory cells 100 connected in series with one another to ground 710. This way, the plurality of memory cells 100 in the first leg of memory cells 100 are read in series by applying the read current 730 to these memory cells 100 in series from the read latch circuit 720 to ground 710. Similarly, the plurality of memory cells 100 in the second leg of memory cells 100 are read in series by applying the read current 730 to these memory cells 100 in series from the read latch circuit 720 to ground 710. By electrically serially connecting the plurality of memory cells 100 along the read current 730 path within each respective leg of memory cells 100, the configuration bit may be more resilient to MTJ short failures. A short failure may occur when the insulator layer is damaged or defective and consequently the resistance of that MTJ becomes very small. When the plurality of memory cells 100 in the first leg of memory cells are electrically connected in series, the read current 730 may flow from the read latch circuit 720, through the plurality of memory cells 100 in the first leg of memory cells 100 to ground 710. Thus, a short in one MTJ within a memory cell 100 may not completely disrupt the read operation because the total resistance of the series-connected memory cells 100 may not be completely shorted due to the presence of the non-shorted MTJs within at least one memory cell 100 in the series. Additional advantages of the configuration bit of FIGS. 7A-7B may include averaging of the read signal over multiple memory cells and adjustability of the insulator layer RA and resistance, similar to the advantages discussed previously with respect to certain other embodiments.

Similarly, FIG. 7B illustrates the read operation 700B with a logical state 1 corresponding to the write operation with a logical state 1 in FIG. 6B. Read operation 700B may be substantially similar to read operation 700A as described with respect to FIG. 7A except for the plurality of memory cells 100 in the first leg and the second leg of memory cells 100 may have an inverse polarity.

Although FIGS. 6A-7B show two memory cells 100 in each leg, the number of memory cells 100 in each leg may be any number. For example, 1 to 16 memory cells 100 may be included in each leg, with simultaneous writing of 2 to 4 memory cells. It should be noted that other combinations are possible, as they would be apparent to one of ordinary skill in the art in view of the present disclosure.

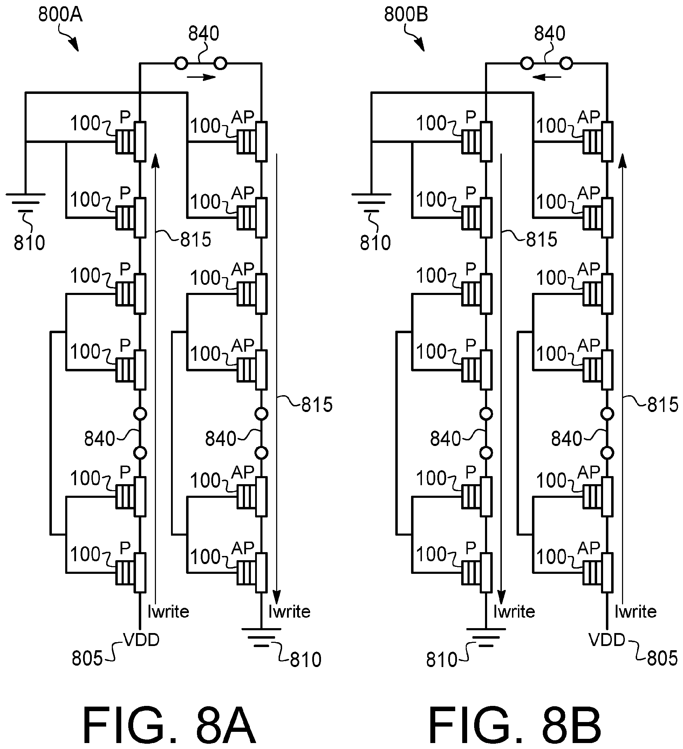

FIGS. 8A and 8B depict an exemplary configuration bit with SOT during a write operation, according to one or more embodiments. FIGS. 8A and 8B are substantially similar to FIGS. 4A and 4B, except for the additional memory cells 100 and switches 840. FIG. 8A illustrates a write operation 800A (e.g., write 0) for a configuration bit with a plurality of memory cells 100. The write operation 800A may include a VDD 805, a plurality of memory cells 100, a ground 810, a write current 815, and one or more switches 840. Each of the plurality of memory cells 100 may be electrically connected in series with a first leg of memory cells 100 having a first polarity (e.g., parallel or "P") and a second leg of memory cells 100 having a second polarity (e.g., antiparallel or "AP")) opposite the first polarity. The logical state of the configuration bit may be, e.g., a logical 0 or 1 and may be written by applying an electrical current through the SOT write line 70' electrically coupled to each MTJ (e.g., MTJ 50) as part of the memory cell 100 in a first direction from a VDD 805 (e.g., voltage source) to ground 810 (shown at bottom right of FIG. 8A). The write operation 800A may be configured to provide a single write current 815 that may flow through each of the memory cells 100 of the first leg, through the one or more closed switches 840, and through each of the memory cells 100 of the second leg, thereby writing the configuration bit to a first logical state.

Similarly, FIG. 8B illustrates the write operation 800B (e.g., write 1) for a configuration bit with a plurality of memory cells 100. The write current 815 may flow through each of the memory cells 100 of the second leg, through the one or more closed switches 840, and through each of the memory cells 100 of the first leg, thereby writing the configuration bit to a second logical state. The write current 815 of FIG. 8B may flow in the opposite direction from the write current 815 of FIG. 8A. An advantage of providing a single write current with all memory cells in electrical series may include a simpler write driver with less total current. Although only six memory cells 100 are shown in each leg illustrated in FIGS. 8A and 8B, there may be any number of memory cells used therein.

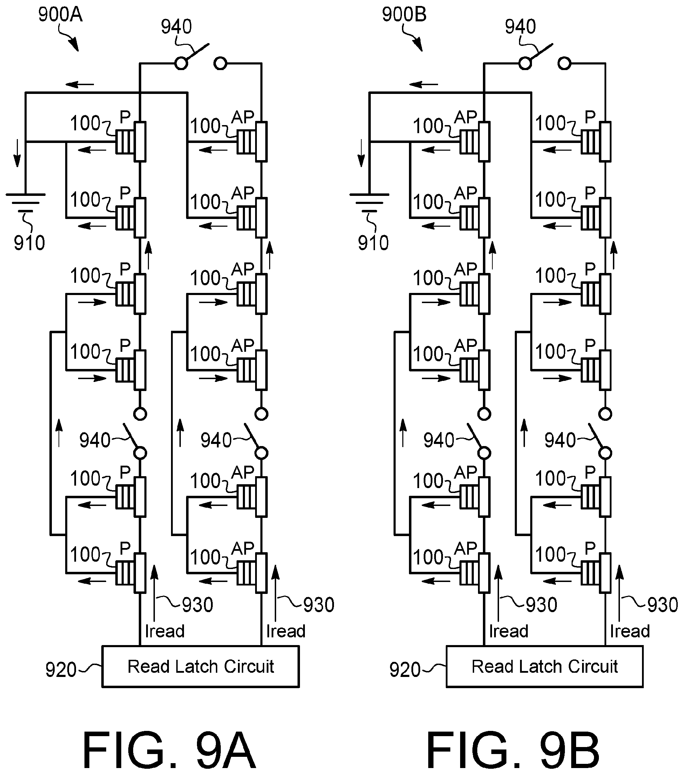

FIGS. 9A and 9B depict an exemplary configuration bit with SOT during a read operation, according to one or more embodiments. FIGS. 9A and 9B illustrate the read operation after the write operation according to FIGS. 8A and 8B, respectively. FIG. 9A illustrates the read operation 900A with a logical state 0 corresponding to the write operation with a logical state 0 in FIG. 8A. Read operation 900A may include ground 910, a read latch circuit 920, a read current 930, and one or more switches 940. As discussed above with respect to FIG. 8A, the first leg may include a plurality of memory cells 100 with a polarity of parallel and a second leg including a plurality of memory cells 100 with a polarity of anti-parallel. For each leg of memory cells 100, the read latch circuit 920 may be configured to provide the read current 930 through the plurality of memory cells 100 in the leg, that have a combination of parallel and series connection, to ground 910. The read latch circuit 920 may determine a difference in resistance between the two legs (e.g., through determining the polarity of each memory cell 100 in the two legs) to determine the state of the configuration bit. The switch 940 may be in the open configuration during a read operation to prevent current flowing between the first leg and the second leg.

Similarly, FIG. 9B illustrates the read operation 900B with a logical state 1 corresponding to the write operation with a logical state 1 in FIG. 8B. Read operation 900B may be substantially similar to read operation 900A as described with respect to FIG. 9A except for the plurality of memory cells 100 in the first leg and the second leg of memory cells 100 may have an inverse polarity.

The configuration bit illustrated in FIGS. 8A-9B has several advantages, including averaging of read signal over multiple memory cells, a combination of parallel and series connections which makes the device more robust against both MTJ open failures and tunnel barrier short failures, and the adjustability of tunnel barrier RA and resistance compared to a scenario where STT devices are used in the configuration bit.

In each leg of the configuration bit shown in FIGS. 8A-9B, a combination of two parallel connections and three series connections are illustrated as an example. However, different combinations of parallel and series connections in each leg are possible. For example, a configuration bit may include $n$ parallel connections multiplied by $m$ series connections in each leg, where $n$ and $m$ are arbitrary positive integers. The combination of parallel and series connections may be chosen based on the MTJ failure characteristics, a required bit error rate, an allowable Silicon (Si) area, and/or other relevant factors. For example, if the MTJ open probability is higher, the number of parallel connections may need to be larger. If the insulator layer short probability is higher, the number of series connections may need to be larger. Furthermore, an increase in the number of MTJs in a leg of MTJs may reduce the bit error rate at the expense of Si area.

In one embodiment, a configuration bit may include a set of MTJs (e.g., as opposed to two sets or legs of MTJs used in earlier embodiments for a differential read between the two sets or legs), and may use a self-reference read technique. In such an implementation, a reading operation may include the following steps: performing a first read operation; performing a write operation on a set of MTJs to a known state; performing a second read operation on the set of MTJs; and comparing the first and second read signals to determine if each MTJ (or a bit cell) switched in response to the write operation. In situations where the known state to which the MTJs are programmed via the second write operation is 1, if the comparing step determines that the state of an MTJ switched, it is determined that the MTJ originally had a logical state of 0. On the other hand, if the comparing step determines that the state of an MTJ did not switch, it is determined that the MTJ originally had a logical state of 1. Thus, based on whether or not the second read is different from the first read, the comparing step reveals which state the MTJ was in before the write operation. One advantage of using self-reference read techniques may include a read circuitry smaller in area since a differential stage for MTJs in both true and complement states may not be needed.

Such an implementation also advantageously does not hurt the cycling endurance because even though a read operation may involve a write operation, the write operation may be performed by SOT, rather than STT, and the SOT write operation may not decrease the write cycling endurance. Cycling endurance refers to the ability of the MTJ device(s) to maintain performance and reliability over repeated write/read cycles. In the configuration bit with STT writing, tunnel barrier breakdown limits the number of write cycles. In the self-reference read technique, each read operation includes write processes. Therefore, the number of allowable read cycles in the configuration bit with STT with the self-reference read is limited. This is one of the shortcomings of the self-reference read. However, as described herein, the configuration bit with SOT writing, the number of allowable write cycles may not limited by the tunnel barrier breakdown, and hence the number of allowable read cycles may not be limited by the tunnel barrier breakdown. In this way, the self-reference read technique applied to a configuration bit utilizing SOT writing mitigates or eliminates the aforementioned shortcoming of the self-reference read technique applied to a configuration bit utilizing STT writing. The circuit that performs the write operation (e.g., a write circuit driver) may also take up less surface area on the chip because it does not require a second set of MTJs, which may be needed under a differential read setting. In one example, the circuit that performs the write operation may be half the area of other embodiments using a differential read technique because half of the MTJs are removed. The sense amplifier used in this implementation is smaller than that of the differential read embodiments because the self-reference read directly compares the read signal for a given set of SOT MTJs against themselves, which is more accurate. This may take full advantage of the MR of corresponding set of SOT MTJs for generating a read signal.

In one embodiment, a configuration bit may include a set of MTJs (e.g., as opposed to two sets or legs of MTJs used in earlier embodiments for a differential read between the two sets or legs), and may use a midpoint reference read technique utilizing a reference resistor. The reference resistor circuit may be set to a value that is at a midpoint between the parallel and antiparallel states of the respective MTJs in the set of MTJs. The resistance of the set of MTJs is compared against the resistance of the reference resistor. Based on whether the resistance of the MTJs is high relative to resistance of the reference resistor or low relative to the resistance of the reference resistor, the logical state of the configuration bit may be determined. The configuration bit may advantageously be, e.g., half the area of certain other implementations described herein because the second set of MTJs is removed. Further, the write current is reduced by half, compared to the other embodiments described herein that used two sets or legs of MTJs.

To get enough read signal at the read latch circuit, and to achieve a highspeed read, the optimum resistance per one leg, Rleg, may range from 1 to 10 kOhm. A larger resistance gives an improved signal-to-noise ratio. However, beyond 10 kOhm, the read speed can be slower. In other devices (e.g., configuration bit with STT), the RA product of the MTJ tunnel barriers may be limited to around 10 $\Omega\mu m^2$ to supply enough write current across the tunnel barriers while ensuring reliability against tunnel barrier breakdown during write cycling. Therefore, it may be challenging to obtain the optimum resistance per leg for read.

In the implementations described herein, the RA product of the MTJ may be optimized for read because of the 3-terminal SOT device. The relation between the MTJ resistance in the P-state, Rmin, and the resistance per one leg, Rleg, depends on the number of series connections, m, and the number of parallel connections, n, as follows: $Rmin = \frac{nRleg}{m}$. Also, the RA product of the MTJ is expressed as $RA = \pi Rmin \left(\frac{eCD}{2}\right)^2$ where eCD is a diameter of the conducting area of the tunnel barrier.

As an example, calculations herein, included by way of example only, assume Rleg = 10 kOhm. The current typical eCD may be from 50 to 90 nm. In other devices, e.g., configuration bits with STT, RA may be from 5 to 10 $\Omega\mu m^2$ due to write and endurance cycling considerations. For embodiments described in FIGS. 2A-2B and 3A-B, where m=1 and n=4, the optimum RA for a read may be 79 to 254 $\Omega\mu m^2$. For the embodiment described in FIGS. 6A-B and 7A-7B, where m=2 and n=1, the optimum RA for read may be 10 to 32 $\Omega\mu m^2$. For embodiments in FIGS. 8A-B and 9A-9B, where m=3 and n=2, the optimum RA for read may be 13 to 42 $\Omega\mu m^2$. Such high RA may be implemented, as opposed to STT devices. In addition, the higher RA brings a higher MR ratio. From these two effects, the larger signal-to-noise ratio and the higher speed read can be obtained.

Regarding MTJ scaling to smaller eCD values of 20 to 40 nm, for example, shrinking the MTJ size is desirable to get a higher density and lower cost memory. In other devices (e.g., configuration bits with STT), RA at these eCD values may be 1 to 4 $\Omega\mu m^2$ for write and endurance cycling. In a tunnel barrier with such low RA values, two problems arise: (1) the MR ratio decreases, and (2) the density of pinhole defects increases. For embodiments in FIGS. 2A-2B and 3A-B, where m=1 and n=4, the optimum RA for read may be 13 to 50 $\Omega\mu m^2$. For embodiments in FIGS. 6A-B and 7A-7B, where m=2 and n=1, the optimum RA for read may be 1.6 to 6 $\Omega\mu m^2$. For embodiments in FIGS. 8A-B and 9A-9B, where m=3 and n=2, the optimum RA for read may be 2.1 to 8 $\Omega\mu m^2$. In the implementations described herein, a higher RA can be used than in STT devices, which ensures a high MR ratio for read. Therefore, a larger signal-to-noise ratio and higher speed read can be obtained.

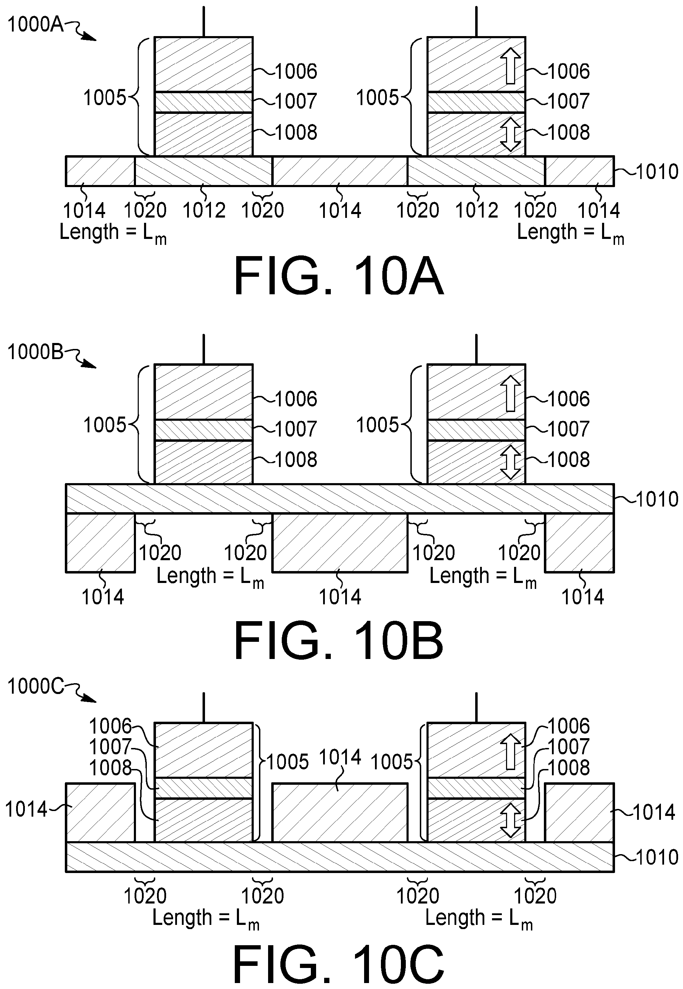

FIGS. 10A, 10B, and 10C depict exemplary SOT channel layers, according to one or more embodiments. The embodiments illustrated in FIGS. 10A-10B may be utilized for the SOT channels described in the other embodiments in the current disclosure. FIG. 10A illustrates SOT channel structure 1000A, which may include MTJs 1005 and SOT channel 1010. The MTJ 1005 may be substantially similar the MTJ 50 as previously described with respect to FIG. 1A. MTJ 1005 may include intermediate region 1007 positioned between a free region 1008 and a fixed region 1006. The fixed region 1006, the intermediate region 1007, and the free region 1008 may be substantially similar to the fixed region 30, the intermediate region 20, and the free region 10 as described in reference to FIG. 1A. The SOT channel 1010 may include one or more first portions 1012 disposed adjacent the MTJs 1005 and one or more second portions 1014 disposed between the MTJs 1005. The material for the one or more first portions 1012 of the SOT channel 1010 may be consistent with the existing SOT channel material, e.g., heavy metal such as platinum (Pt), tungsten (W), or the like.

As previously described, the SOT channel 1010 may include materials adjacent to the free region 1008 that, when a current passes through the SOT channel 1010, change the orientation of the magnetic moments of the electrons in the free region 1008. The SOT channel 1010 may include high-resistance material(s) relative to other conductive materials because such materials that are conducive to an SOT current running therethrough, such as platinum (Pt), tantalum (Ta), tungsten (W), tantalum oxide (TaOx), Hf, V, W-nitride, W/W-nitride multilayers, Pt/Au multilayers, PtAu alloys Bi2Se3, and Bi2Te3, often have high resistance. However, high resistance generates heat losses and degrades reliability and energy efficiency of devices. Therefore, to improve conductivity between MTJ devices, a conductive material with low resistance, such as low resistance metal, may electrically couple portions of the SOT channel 1010 (e.g., one or more second portions 1014).

The material for one or more second portions 1014 of the SOT channel 1010 may include a low resistive material, e.g., low resistive metal such as aluminum (Al), copper (Cu), or the like. The low resistance material may be within the SOT channel 1010, may provide paths of less resistance for a current traveling therethrough. By including the conductive, low resistance material within portions of the SOT channel 1010, the speed of current travel is increased while heat losses are decreased. In each of the embodiments described above (e.g., FIGS. 2A-9B), the conductive, low resistance materials may include low resistance metal, such as, e.g., copper. In addition, though the magnetic moments in the free region 1008 and fixed region 1006 as described herein are shown perpendicular to the plane of the film, either in-plane or out-of-plane magnetized free and fixed regions may be used in the MTJs for any of the embodiments in this disclosure.

Referring now to FIG. 10A, SOT channel 1010 may further include a length 1020 (e.g., Lm) between an edge of the MTJ 1005 and the edge of the one or more first portions 1012. The length 1020 may refer to a distance and MTJ may be away from the conductive material to operate without experiencing performance losses due to, for example, having the conductive material extend too far inside the diameter of the MTJ so that the conductive layer may preferably shunt current away from the SOT channel and therefore reduce the efficiency of the SOT writer mechanism. The length 1020 may be small, for example approximately between +40 and -5 nm or approximately between +50% and -10% of the MTJ diameter. The inclusion of the conductive material in electrical contact with the SOT channel (e.g., first portions 1012 and second portions 1014) may reduce parasitic resistances along read current paths, and hence improve the signal-to-noise ratio in the read signal. This may further reduce the power consumption and Joule heating to result in an improved reliability.

FIGS. 10B and 10C illustrate an alternate method of using a low resistive material for portions (e.g., one or more second portions 1014) of the SOT channel 1010, which is discussed above with respect to FIG. 10A.

Instead of having alternating segments of first portions 1012 and second portions 1014 horizontally in the SOT channel 1010 of FIG. 10A, the SOT channel 1010 as described in connection with FIGS. 10B-10C may at least largely comprise the material for the one or more first portions 1012 discussed above (e.g., material consistent with the existing SOT channel material, e.g., heavy metal such as platinum (Pt), tungsten (W), or the like), and may extend continually while one or more second portions 1014 abut the SOT channel 1010 at regular intervals. Therefore, instead of replacing portions of the SOT channel 1010 with low resistive materials (e.g., second portion 1014), a metal line (e.g., one or more second portions 1014) touching the bottom (e.g., SOT channel structure 1000B of FIG. 10B) or top (e.g., SOT channel structure 1000C of FIG. 10C) of the SOT channel material (e.g., SOT channel 1010) may be formed. In such an implementation, similar performance gains are realized because the path of least resistance between MTJs includes the conductive material, through which the current may flow. As similarly described in reference to FIG. 10A, length 1020 may be implemented as a reference distance between the edge of an MTJ and the edge of the one or more second portions 1014. In another embodiment, the first portion 1012 of FIG. 10A or the SOT channel 1010 of FIGS. 10B-10C may be thin ferromagnetic metal with in-plane magnetization comprising cobalt (Co), iron (Fe), boron (B), cobalt-iron (CoFe), cobalt-iron-boron (CoFeB), or their alloys, and the second portion 1014 of FIGS. 10A-10C may be thick antiferromagnet comprising platinum-manganese (PtMn) or iridium-manganese (IrMn). In this case, the exchange bias from the second portion 1014 to the first portion 1012 of FIG. 10A or to the SOT channel 1010 of FIGS. 10B-10C may align the magnetization direction of the first portion 1012 of FIG. 10A or the SOT channel 1010 of FIGS. 10B-10C to one direction across the whole MRAM array, which may achieve a precise and uniform field free switching for a perpendicular free layer.

In one embodiment, the present disclosure is drawn to a configuration bit, comprising: a first set of magnetic tunnel junctions (MTJs) having a first polarity; a second set of MTJs having a second polarity opposite the first polarity; and a reading device electrically connected to the first set of MTJs and to the second set of MTJs, the reading device configured to read a difference between the first polarity of the first set of MTJs and the second polarity of the second set of MTJs, wherein each MTJ in the first set of MTJs and each MTJ in the second set of MTJs is electrically connected to a respective spin orbit torque (SOT) channel layer configured to, when a current is applied to the SOT channel layer, control the polarities of the first set of MTJs and the second set of MTJs based on a direction of the current.

Various aspects of the present disclosure may also include: wherein the SOT channel layer electrically connects each MTJ in the first set of MTJs in series with one another, and wherein the read device is configured to read each MTJ in the first set of MTJs electrically in parallel with one another; wherein the SOT channel layer electrically connects each MTJ in the second set of MTJs in series with one another, and wherein the read device is configured to read each MTJ in the second set of MTJs electrically in parallel with one another; wherein the SOT channel layer electrically connects each MTJ in the first set of MTJs in series with one another, and wherein the read device is configured to read each MTJ in the first set of MTJs in electrical series with one another; wherein the SOT channel layer electrically connects each MTJ in the second set of MTJs in series with one another, and wherein the read device is configured to read each MTJ in the second set of MTJs in electrical series with one another; wherein the first set of MTJs is connected in electrical series with the second set of MTJs through the SOT channel layer; the configuration bit further comprising a switch electrically connected between the first set of MTJs and the second set of MTJs; and wherein each MTJ in the first set of MTJs and the second set of MTJs includes an insulator layer through which electric current flows when the reading device reads the polarity of the first set of MTJs and the polarity of the second set of MTJs.

In another embodiment, the present disclosure is drawn to a configuration bit, comprising: one or more first magnetic tunnel junctions (MTJs) having a first polarity; one or more second MTJs having a second polarity opposite the first polarity; and a reading device electrically connected to the one or more first MTJs and to the one or more second MTJs, the reading device configured to read the first polarity of the one or more first MTJs and the second polarity of the one or more second MTJs, wherein each MTJ of the one or more first MTJs and each MTJ of the one or more second MTJs is electrically connected to a respective spin orbit torque (SOT) channel layer configured to, when a current is applied to the SOT channel layer, control the polarities of the one or more first MTJs and the one or more second MTJs based on a direction of the current.

Various aspects of the present disclosure may also include: wherein the SOT channel layer electrically connects each MTJ of the one or more first MTJs in series with one another, and wherein the read device is configured to read each MTJ of the one or more first MTJs electrically in parallel with one another; wherein the SOT channel layer electrically connects each MTJ of the one or more second MTJs in series with one another, and wherein the read device is configured to read each MTJ of the one or more second MTJs electrically in parallel with one another; wherein the SOT channel layer electrically connects each MTJ of the one or more first MTJs in series with one another, and wherein the read device is configured to read each MTJ of the one or more first MTJs in electrical series with one another; wherein the SOT channel layer electrically connects each MTJ of the one or more second MTJs in series with one another, and wherein the read device is configured to read each MTJ of the one or more second MTJs in electrical series with one another; the configuration bit further comprising a switch between the one or more first MTJs and the one or more second MTJs; the configuration bit further comprising a switch between the one or more first MTJs and the one or more second MTJs, wherein the switch is closed during a write operation; and the configuration bit further comprising a switch between the one or more first MTJs and the one or more second MTJs, wherein the switch is open during a read operation.

In yet another embodiment, the present disclosure is drawn to a configuration bit, comprising: at least one set of magnetic tunnel junctions (MTJs); a reading device electrically connected to the at least one set of MTJs, the reading device configured to read a polarity of each MTJ in the at least one set of MTJs, wherein each MTJ in the at least one set of MTJs is connected to a respective spin orbit torque (SOT) channel layer having a first conductivity and configured to, when a current is applied to the SOT channel layer, control the polarity of the MTJ based on a direction of the current, wherein the SOT channel layer is electrically serially connected with a conductive material having a second conductivity greater than the first conductivity.

Various aspects of the present disclosure may also include: wherein the conductive material electrically serially connects respective portions of the SOT channel layer beneath the MTJs; wherein the conductive material is within the SOT channel layer; and wherein the conductive material is above or below the SOT channel layer.

Other embodiments of the disclosure will be apparent to those skilled in the art from consideration of the specification and practice of the embodiment(s) disclosed herein. It is intended that the specification and examples be considered as exemplary only, with a true scope and spirit of the embodiment(s) being indicated by the following claims.

While exemplary embodiments have been presented above, it should be appreciated that many variations exist. Furthermore, while the description includes references to memory cells and devices, the teachings may be applied to other memory devices having different architectures in which the same concepts can be applied. Thus, the particular embodiments disclosed above are illustrative only and should not be taken as limitations, as the embodiments may be modified and practiced in different but equivalent manners apparent to those skilled in the art having the benefit of the teachings herein. Accordingly, the foregoing description is not intended to limit the disclosure to the particular form set forth, but on the contrary, is intended to cover such alternatives, modifications and equivalents as may be included within the spirit and scope of the inventions as defined by the appended claims so that those skilled in the art should understand that they can make various changes, substitutions and alterations without departing from the spirit and scope of the inventions in their broadest form.

The foregoing description of the inventions has been described for purposes of clarity and understanding. It is not intended to limit the inventions to the precise form disclosed. Various modifications may be possible within the scope and equivalence of the application.

**Claims**

1. A configuration bit, comprising:

   a first set of magnetic tunnel junctions (MTJs) having a first polarity;
   a second set of MTJs having a second polarity opposite the first polarity; and
   a reading device electrically connected to the first set of MTJs and to the second set of MTJs, the reading device configured to read a difference between the first polarity of the first set of MTJs and the second polarity of the second set of MTJs,
   wherein each MTJ in the first set of MTJs and each MTJ in the second set of MTJs is electrically connected to a respective spin orbit torque (SOT) channel layer configured to, when a current is applied to the SOT channel layer, control the polarities of the first set of MTJs and the second set of MTJs based on a direction of the current.

2. The configuration bit of claim 1, wherein the SOT channel layer electrically connects each MTJ in the first set of MTJs in series with one another, and wherein the read device is configured to read each MTJ in the first set of MTJs electrically in parallel or in electrical series with one another.

3. The configuration bit of claim 1 or 2, wherein the SOT channel layer electrically connects each MTJ in the second set of MTJs in series with one another, and wherein the read device is configured to read each MTJ in the second set of MTJs electrically in parallel or in electrical series with one another.

4. The configuration bit of one of the preceding claims, wherein the first set of MTJs is connected in electrical series with the second set of MTJs through the SOT channel layer.

5. The configuration bit of one of the preceding claims, further comprising a switch electrically connected between the first set of MTJs and the second set of MTJs.

6. The configuration bit of one of the preceding claims, wherein each MTJ in the first set of MTJs and the second set of MTJs includes an insulator layer through which electric current flows when the reading device reads the polarity of the first set of MTJs and the polarity of the second set of MTJs.

7. A configuration bit, comprising:

one or more first magnetic tunnel junctions (MTJs) having a first polarity;
one or more second MTJs having a second polarity opposite the first polarity; and
a reading device electrically connected to the one or more first MTJs and to the one or more second MTJs, the reading device configured to read the first polarity of the one or more first MTJs and the second polarity of the one or more second MTJs,
wherein each MTJ of the one or more first MTJs and each MTJ of the one or more second MTJs is electrically connected to a respective spin orbit torque (SOT) channel layer configured to, when a current is applied to the SOT channel layer, control the polarities of the one or more first MTJs and the one or more second MTJs based on a direction of the current.

8. The configuration bit of claim 7, wherein the SOT channel layer electrically connects each MTJ of the one or more first MTJs in series with one another, and wherein the read device is configured to read each MTJ of the one or more first MTJs electrically in parallel or in electrical series with one another.

9. The configuration bit of claim 7 or 8, wherein the SOT channel layer electrically connects each MTJ of the one or more second MTJs in series with one another, and wherein the read device is configured to read each MTJ of the one or more second MTJs electrically in parallel or in electrical series with one another.

10. The configuration bit of one of claims 7 to 9, further comprising a switch between the one or more first MTJs and the one or more second MTJs.

11. The configuration bit of claim 10, wherein the switch is closed during a write operation, and/or wherein the switch is open during a read operation.

12. A configuration bit, comprising:

at least one set of magnetic tunnel junctions (MTJs);
a reading device electrically connected to the at least one set of MTJs, the reading device configured to read a polarity of each MTJ in the at least one set of MTJs,
wherein each MTJ in the at least one set of MTJs is connected to a respective spin orbit torque (SOT) channel layer having a first conductivity and configured to, when a current is applied to the SOT channel layer, control the polarity of the MTJ based on a direction of the current, wherein the SOT channel layer is electrically serially connected with a conductive material having a second conductivity greater than the first conductivity.

13. The configuration bit of claim 12, wherein the conductive material electrically serially connects respective portions of the SOT channel layer beneath the MTJs.

14. The configuration bit of claim 12 or 13, wherein the conductive material is within the SOT channel layer.

15. The configuration bit of claim 12 or 13, wherein the conductive material is above or below the SOT channel layer.

FIG. 1A

110

Read Latch Circuit

100B

150
Iwrite

130
VDD

150
Iwrite

120 AP

P

P

P

P AP

AP

AP

AP

130
VDD

150
Iwrite

150
Iwrite

GND
140

# FIG. 1B

170

110

Read Latch Circuit

160
Iread

P

P

P

P

120 AP

AP

AP

AP

120

160
Iread

GND
140

180

110

Read Latch Circuit

160
Iread

AP

AP

AP

AP

120 P

P

P

P

120

160
Iread

GND
140

# FIG. 1C

200A

210                210

P                  P

100                100

P                  P

205             100    100
VDD

215    Iwrite

## FIG. 2A

250A

205                205
VDD                VDD

AP                 AP

100    100         100    100

AP                 AP

210    100    100

215    Iwrite

200B

205                205
VDD                VDD

AP                 AP

100    100         100    100

AP                 AP

210         100    100

215    Iwrite

## FIG. 2B

250B

210                210

205                P                  P
VDD

100    100         100    100

205                P                  P
VDD

100    100         100    100

215    Iwrite

300A

210   210   210   210

100 P   100 P   100 AP   100 AP

100 P   100 P   100 AP   100 AP

230 Iread   Iread 230

220 Read Latch Circuit

# FIG. 3A

300B

210   210   210   210

100 AP   100 AP   100 P   100 P

100 AP   100 AP   100 P   100 P

230 Iread

220 Read Latch Circuit

# FIG. 3B

FIG. 4A

FIG. 4B

FIG. 5A

FIG. 5B

600A

640

100 P    100 AP

100 P    100 AP

615    615

Iwrite    Iwrite

605 VDD    610

# FIG. 6A

600B

640

100 AP    100 P

100 AP    100 P

615    615

Iwrite    Iwrite

610    VDD 605

# FIG. 6B

700A

740

100 P    100 AP

710

100 P    100 AP

730    730
Iread    Iread

Read Latch Circuit    720

# FIG. 7A

700B

740

100 AP    100 P

710

100 AP    100 P

730    730
Iread    Iread

Read Latch Circuit    720

# FIG. 7B

FIG. 8A

FIG. 8B

FIG. 9A

FIG. 9B

1000A

1005 {
~1006
~1007
~1008

1005 {
~1006
~1007
~1008

~1010

1014  1020  1012  1020      1014      1020  1012  1020  1014
Length = L$_m$                                    Length = L$_m$

# FIG. 10A

1000B

1005 {
~1006
~1007
~1008

1005 {
~1006
~1007
~1008

~1010

1020      1020          1020      1020
1014    Length = L$_m$    1014    Length = L$_m$    1014

# FIG. 10B

1000C

1006
1007
1008

1005  1014  1005

1006
1007
1008

1014~                                          ~1014

~1010

1020      1020          1020      1020
Length = L$_m$              Length = L$_m$

# FIG. 10C

24

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 63634183
- US 590543
- US 11127896 B
- US 8686484 B
- US 8747680 B
- US 9023216 B
- US 9136464 B
- US 9419208 B
- US 83173617
- US 62591945 B
- US 62594229 B
- US 62580612 B
- US 62582502 B
- US 62588158 B
- US 62653796 B